Europäisches Patentamt

European Patent Office

Office européen des brevets

Numéro de publication: **0 367 691**

**A1**

## DEMANDE DE BREVET EUROPEEN

Numéro de dépôt: **89420415.5**

Int. Cl.5 **G05B 19/12 , H05K 1/11**

Date de dépôt: **25.10.89**

Priorité: **04.11.88 FR 8815050**
**04.11.88 FR 8815057**

Date de publication de la demande:
**09.05.90 Bulletin 90/19**

Etats contractants désignés:
**BE CH DE ES GB IT LI SE**

Demandeur: **MERLIN GERIN**
**2, chemin des Sources**
**F-38240 Meylan(FR)**

Inventeur: **Bouchaud, Jean-Louis**
**Merlin Gerin Sce. Brevets**
**F-38050 Grenoble Cédex(FR)**
Inventeur: **Chevaleyre, Robert**
**Merlin Gerin Sce. Brevets**
**F-38050 Grenoble Cédex(FR)**

Mandataire: **Kern, Paul et al**
**Merlin Gerin Sce. Brevets 20, rue Henri Tarze**
**F-38050 Grenoble Cédex(FR)**

### Ensemble de contrôle technique de bâtiment, à mémoire embrochable de paramètrage.

Une cartouche embrochable (130) contient une mémoire amovible de type EEPROM dans laquelle sont mémorisés les paramètres correspondants à des configurations standards. La sélection, par le clavier (128) de l'unité centrale (110) de l'ensemble de contrôle, d'une configuration standard particulière, provoque le transfert des paramètres correspondants de la mémoire amovible à la mémoire vive (124) de l'unité centrale, effectuant ainsi un paramètrage automatique de l'ensemble. Les paramètres peuvent ultérieurement être modifiés dans la mémoire vive et la configuration modifiée peut être recopiée dans des emplacements vides de la mémoire amovible.

FIG. 1

Fig. 2

EP 0 367 691 A1

## ENSEMBLE DE CONTROLE TECHNIQUE DE BATIMENT, A MEMOIRE EMBROCHABLE DE PARAMETRAGE.

L'invention concerne un ensemble de contrôle technique de bâtiment. comportant une unité centrale destinée à être connectée à une pluralité de capteurs et d'actionneurs pour traiter les données fournies par les capteurs et commander les actionneurs. l'unité centrale comportant un microprocesseur, au moins une mémoire vive secourue, un clavier et un dispositif d'affichage.

La programmation initiale de tels ensembles de contrôle, parfois dénommés automates de gestion technique de bâtiment, nécessite l'entrée dans la mémoire vive d'un nombre de paramètres qui peut être important. A titre d'exemple une application particulière peut nécessiter l'entrée de plusieurs centaines de paramètres. Il est clair qu'une telle programmation est longue et fastidieuse.

L'invention a pour but de simplifier au maximum la programmation initiale de l'ensemble.

Selon l'invention ce but est atteint par le fait que l'ensemble comporte une mémoire amovible, du type mémoire morte programmable et effaçable électriquement, contenant les paramètres associés à une pluralité de configurations standards correspondant à une pluralité d'applications standards prédéterminées de l'ensemble, la mémoire amovible étant disposée dans une cartouche embrochable destinée à être connectée temporairement à l'unité centrale pour la programmation initiale de l'ensemble, à sa mise en service, de manière à permettre le transfert de la mémoire amovible à la mémoire vive des paramètres associés à une configuration sélectionnée par le clavier.

Un tel ensemble est, en effet, généralement utilisé pour des applications connues et, pour une application d'un type donné, la plupart des paramètres sont toujours identiques. Une cartouche embrochable contenant en mémoire l'ensemble des configurations standards généralement utilisées dans un domaine d'application particulier permet donc à l'opérateur de programmer automatiquement l'ensemble en connectant la cartouche embrochable sur l'unité centrale et en sélectionnant à l'aide du clavier la configuration correspondant à ses besoins.

Afin de laisser une souplesse suffisante à l'ensemble, il est souhaitable de permettre une modification des paramètres standards ainsi programmés. Selon un développement de l'invention, les paramètres contenus dans la mémoire vive peuvent être affichés successivement sur le dispositif d'affichage, et complétés ou modifiés sous le contrôle du clavier.

De plus, la mémoire amovible comporte des emplacements de mémoire vides et, certains paramètres introduits dans la mémoire vive étant complétés ou modifiés par l'intermédiaire du clavier, l'ensemble des paramètres est transférable. sous le contrôle du clavier, de la mémoire vive à des emplacements de mémoire vides présélectionnés de la mémoire amovible de manière à constituer une copie de sauvegarde de la configuration modifiée.

La connexion du dispositif amovible à l'unité centrale lorsque celle-ci est sous-tension peut, si l'on ne prend aucune précaution, conduire à la perturbation ou à l'endommagement de certains circuits, aussi bien dans l'unité centrale que dans le circuit de mémoire.

Selon un développement de l'invention, pour fournir une protection efficace de ces différents circuits sans nécessiter l'utilisation de circuits électroniques de protection additionnels. l'unité centrale comporte une première carte de circuit imprimé portant au moins le microprocesseur de l'unité centrale. la cartouche embrochable comportant une seconde carte de circuit imprimé, l'une des deux cartes comportant une plage de connexion de pistes d'alimentation et de pistes de transmission de données sur laquelle est destiné à venir d'embrocher un connecteur, solidaire de l'autre carte et connecté électriquement à des pistes d'alimentation et de données de ladite autre carte, les extrémités des pistes d'alimentation de ladite plage de connexion étant décalées par rapport aux extrémités des pistes de transmission de données de ladite plage, de manière à venir en contact avec le connecteur avant ces dernières lors de l'embrochage du connecteur, les pistes d'alimentation étant, dans la plage de connexion, disposées de part et d'autre des pistes de transmission de données.

De cette manière le dispositif amovible comportant la mémoire est obligatoirement alimenté avant que les pistes de transmission de données soient raccordées, assurant ainsi intrinsèquement la protection des circuits.

Selon un mode particulier de réalisation, le bord de la carte est échancré dans la partie de la plage de connexion correspondant aux pistes de transmission de données.

Selon un développement de l'invention, la plage de connexion comporte, sur une face de la carte, de part et d'autre des pistes de transmission de données, deux pistes d'alimentation adjacentes de polarités opposées, les pistes extérieures étant de même polarité, des pistes d'alimentation pouvant être disposées sur les deux faces opposées de la carte de manière symétrique par rapport au plan de la carte si l'on utilise un circuit imprimé double face.

Cette disposition des pistes dans la plage de connexion élimine tout risque de connexion incorrecte des pistes d'alimentation quelle que soit la position du connecteur au moment de l'embrochage, même en cas de retournement du connecteur. En pratique, la carte est normalement disposée dans un boîtier comportant un dispositif de détrompage de manière à permettre l'embrochage du connecteur dans un sens prédéterminé seulement.

Cependant, il arrive, notamment en cours d'essais, que la connexion soit effectuée en l'absence de boîtiers et il est alors souhaitable que le retournement du connecteur ne conduise pas à une connexion erronée des pistes d'alimentation.

Dans le cas de l'utilisation d'un circuit double face, le même résultat peut également être obtenu grâce à une plage de connexion comportant sur une première face une piste d'alimentation d'une polarité à une première extrémité et une piste d'alimentation de polarité opposée à l'autre extrémité, et inversement sur la face opposée.

D'autres avantages et caractéristiques ressortiront plus clairement de la description qui va suivre de différents modes de réalisation de l'invention, donnés à titre d'exemples non limitatifs et représentés aux dessins annexés, dans lesquels:

La figure 1 représente, de façon schématique, un ensemble selon l'invention;

La figure 2 représente schématiquement une carte de circuit imprimé de l'unité centrale de l'ensemble selon la figure 1, et un connecteur, solidaire d'un organe amovible, destiné à venir s'embrocher sur la carte;

La figure 3 illustre, en coupe, l'introduction de la carte dans le connecteur;

Les figures 4 à 6 représentent, diverses dispositions possibles des pistes d'alimentation sur une plage de connexion, vue en bout, d'une carte selon la figure 2;

Les figures 7 à 9 illustrent diverses positions relatives possibles du connecteur et de la carte lors de l'embrochage.

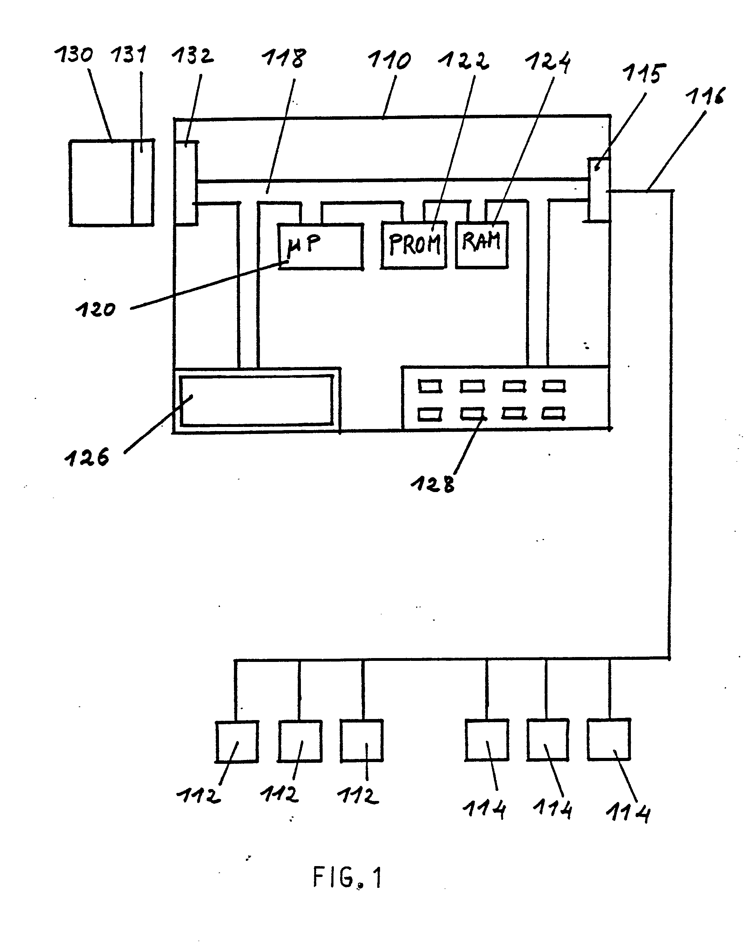

L'ensemble représenté sur la figure 1 comporte essentiellement une unité centrale 110 destinée à être raccordée, si nécessaire par l'intermédiaire d'interfaces appropriées à des capteurs 112 et à des actionneurs 114. Dans le mode de réalisation préférentiel représenté sur la figure, cette connexion est réalisée par l'intermédiaire d'un réseau 116 de transmission de données connecté au bus interne 118 de l'unité centrale par l'intermédiaire de l'interface 115.

Le nombre et la nature des capteurs et des actionneurs dépend du type d'application pour laquelle l'ensemble est utilisé.

Sur la figure sont schématisés les éléments de l'unité centrale, indispensables à la compréhension de l'invention, à savoir un microprocesseur 120, une mémoire morte (ROM) 122, une mémoire vive (RAM) secourue 124, un dispositif d'affichage numérique 126 et un clavier 128. Sur la figure tous ces éléments sont connectés au bus interne 118. Il est bien évident que l'invention n'est pas limitée à une telle structure et que tout type d'unité centrale comportant au moins ces éléments essentiels pourra être utilisé.

Une mémoire amovible, de type EEPROM, est disposée dans une cartouche embrochable 130. L'embrochage se fait à l'aide des connecteurs 131 et 132 situés sur la cartouche 130 et l'unité centrale 110. En position embrochée de la cartouche, la mémoire amovible est connectée au bus interne 118. Elle est ainsi alimentée par l'unité centrale et il peut y avoir transfert de données entre la mémoire amovible et l'unité centrale.

La mémoire amovible d'une cartouche contient les paramètres associés à un certain nombre de configurations standards, par exemple une trentaine de configurations standards. Pour une configuration standard donnée, le nombre et la nature des capteurs et des actionneurs ainsi que leur mode d'utilisation sont prédéterminés.

A titre d'exemple, un premier type de configurations pourra correspondre à un ensemble destiné au contrôle du chauffage d'un bâtiment, comportant des actionneurs 114 constitués par des modules de contrôle de chauffage et des capteurs 112 constitués par des sondes de température. Chaque configuration de ce type précisera les paramètres nécessaires définissant le matériel utilisé - nombre de modules et nombre de sorties par module, type de sonde - et son utilisation - type de chauffage (par convection, par dalle...), horaires, etc. Un second type de configurations pourra correspondre à l'utilisation d'un ensemble pour le contrôle simultané du chauffage et de l'éclairage d'un bâtiment.

Chaque cartouche sera associée à une liste descriptive des configurations standards qu'elle contient de manière à permettre à l'opérateur de sélectionner la configuration correspondant à son application.

Il est possible de prévoir une bibliothèque de cartouches, chaque cartouche étant plus spécifiquement dédiée à un type particulier d'application, lié par exemple au type de bâtiment à contrôler. A titre d'exemple, une cartouche "Hôtel" pourra contenir les différentes configurations standards nécessaires pour le contrôle technique d'un hôtel, tandis qu'une cartouche "Ecole" contiendra les différentes configurations standards généralement rencontrées dans le contrôle technique d'une école.

Pour le paramétrage de l'ensemble, l'opérateur procède de la manière suivante:

Comme dans les ensembles connus, l'unité centrale 110 est mise sous tension et sous le contrôle du clavier, un sous-programme de paramètrage contenu dans la mémoire morte 122 amorce le dialogue avec l'opérateur par l'intermédiaire du dispositif d'affichage 126. Eventuellement après un premier échange d'informations nécessaire à l'initialisation et à la personnalisation de l'ensemble, une question relative à la configuration choisie est alors affichée. L'opérateur peut alors décider de ne pas utiliser de configuration standard et la programmation s'effectue ensuite de manière classique par l'entrée successive de tous les paramètres nécessaires. Dans le cas contraire, il connecte une cartouche embrochable 130 sur l'unité centrale et sélectionne, par l'intermédiaire du clavier, la configuration correspondant à son application. Le contenu de la mémoire amovible correspondant à la configuration sélectionnée est alors automatiquement transféré dans la mémoire vive 124 de l'unité centrale.

Si la configuration utilisée correspond exactement à la configuration standard sélectionnée, la programmation de l'ensemble est alors terminée. La cartouche 130 est retirée et peut être utilisée pour programmer d'autres ensembles de contrôle.

A tout instant l'opérateur peut vérifier sur le dispositif d'affichage les paramètres entrés dans la mémoire vive 124 en utilisant une touche de fonction "lecture" du clavier.

Si la configuration utilisée, bien que proche de la configuration sélectionnée, diffère de celle-ci sur certains points l'opérateur peut, grâce à un dialogue approprié du clavier, compléter ou modifier les paramètres entrés en mémoire vive. Il fait défiler successivement sur le dispositif d'affichage 126 les paramètres utilisés, un paramètre affiché pouvant soit être validé, soit être modifié par l'opérateur, par l'intermédiaire du clavier. Même si la configuration doit être légèrement complétée ou modifiée, il est évident que l'utilisation de la cartouche facilite considérablement la programmation.

Dans le cas où l'opérateur a effectué des compléments ou modifications à une configuration standard, il peut être souhaitable de sauvegarder la configuration modifiée. Il est prévu sur chaque cartouche des emplacements de mémoire vides destinés à recevoir les données correspondant à au moins une configuration modifiée. Pour effectuer cette sauvegarde, la cartouche est de nouveau connectée à l'unité centrale et, grâce à un dialogue approprié du clavier, l'ensemble des paramètres de la configuration modifiée est transféré dans un des emplacements de mémoire vides de la configuration modifiée. La cartouche comporte alors les configurations standards initiales et la configuration modifiée à sauvegarder.

La configuration sauvegardée peut être utilisée ultérieurement pour reprogrammer l'ensemble en cas de défaillance de l'unité centrale ayant conduit à l'effacement de la totalité ou d'une partie du contenu de la mémoire vive 124, ou pour programmer d'autres ensembles du même type.

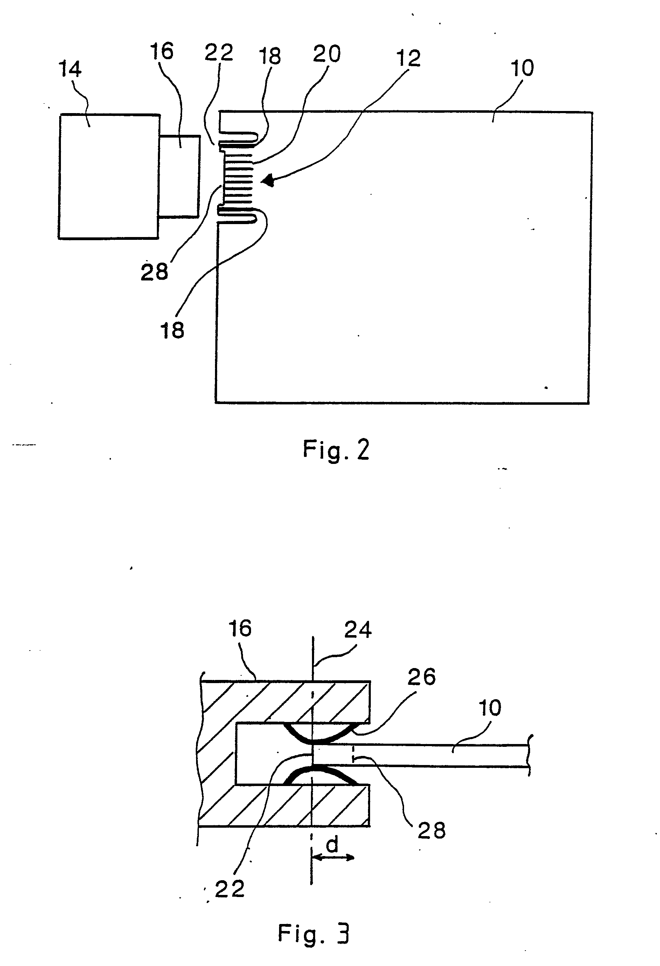

Sur la figure 2 est schématisée une carte de circuit imprimé 10, dite carte-mère, sur laquelle seule la plage de connexion 12 est représentée. Une telle carte comporte au moins le microprocesseur de l'unité centrale de l'ensemble selon la figure 1, et peut porter les différents composants de l'unité centrale. La cartouche amovible 14,destinée à être connectée avec la carte 10, est munie d'un connecteur 16, qui peut par exemple être un connecteur standard de type HE9. Ce connecteur est solidaire d'une carte de circuit imprimé (non représentée), dite carte-fille, disposée à l'intérieur de la cartouche et portant la mémoire de la cartouche. L'embrochage du connecteur 16 sur la plage de connexion 12 doit réaliser la connexion des pistes d'alimentation et des pistes de transmission de données, respectivement, des cartes mère et fille.

Selon un développement de l'invention, dans la plage de connexion 12, les extrémités des pistes d'alimentation 18 sont décalées vers l'extérieur par rapport aux extrémités des pistes de transmission de données 20. De plus les pistes d'alimentation 18 sont disposées de part et d'autre des pistes de transmission de données 20. Ainsi, lors de l'embrochage du connecteur 16 sur la plage de connexion, les pistes d'alimentation 18 viennent toujours en contact avec les contacts associés du connecteur dans le bon sens avant que les pistes de transmission de données 20 ne viennent, elles aussi, en contact avec les contacts correspondants du connecteur.

Ce phénomène est plus clairement illustré sur la figure 3. Lorsque l'extrémité 22 de la carte 10, sur laquelle débouchent les pistes d'alimentation 18, coïncide avec un axe 24 correspondant à la position dans laquelle les contacts 26 du connecteur assurent le contact avec les pistes, le plan 28 correspondant à l'extrémité des pistes de transmission de données n'a pas encore atteint cet axe 24. Dans cette position, les pistes d'alimentation 18 commencent donc à assurer le contact avec les contacts 26 associés du connecteur, tandis qu'il faudra un déplacement relatif supplémentaire de la carte par rapport au connecteur, correspondant à la distance "d" séparant les plans 22 et 28, pour que la connexion des pistes de transmission de données soit également assurée.

La distance "d" doit être supérieure aux tolérances existant dans le connecteur quant au positionnement de l'axe 24 et inférieure à la profondeur du connecteur. Dans la pratique, une distance correspondant à 1.2 pas de grille de circuit imprimé, soit 1,27 mm, s'est avérée satisfaisante.

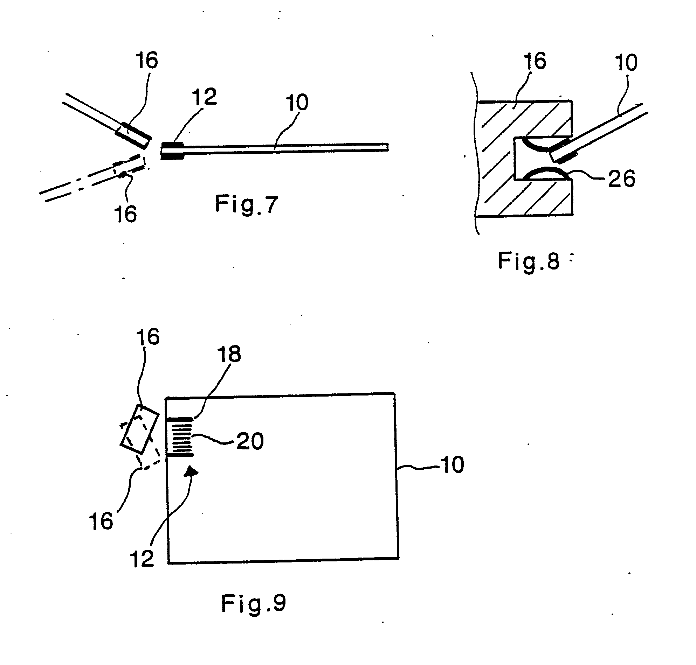

Dans le mode de réalisation représenté sur la figure 2, le bord de la carte 10 est échancré dans la partie de la plage de connexion correspondant aux pistes de transmission de données 18, délimitant ainsi matériellement le plan 28, les extrémités des pistes allant jusqu'au bord de la carte. Cette caractéristique, n'est pas indispensable, notamment lorsque les pistes sont étamées, ce qui est possible lorsque le nombre de manoeuvres d'embrochage prévu est limité - par exemple 50 manoeuvres -. Dans ce cas, la plage de connexion est du type représenté schématiquement sur la figure 9. Par contre, si les pistes sont réalisées par dépôt d'or de manière à résister à un grand nombre de manoeuvres d'embrochage, le mode de réalisation selon la figure 2 est nécessaire.

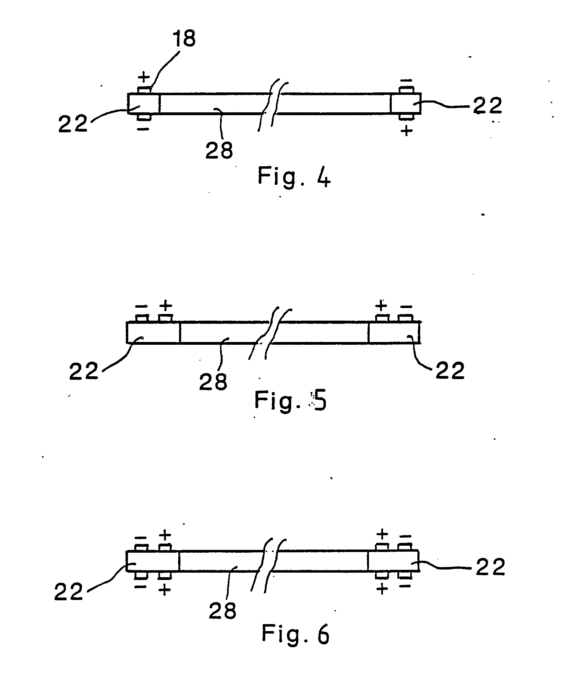

Les figures 4 à 6 illustrent diverses répartitions possibles des pistes d'alimentation à l'intérieur de la plage de connexion. Pour ne pas alourdir inutilement les figures, on n'a pas représenté les pistes de transmission de données qui sont diposées en regard de la paroi 28.

La figure 4 illustre le mode de réalisation préféré de la plage de connexion. Chaque face comporte deux pistes d'alimentation 18, de polarités opposées. Sur les figures, ces polarités sont schématisées par les références + et -, mais il est bien évident que l'une des pistes peut être à la masse, l'autre étant à une tension positive, par exemple + 5V, ou négative, par exemple -5V. Sur la figure 4 à une piste de polarité donnée sur l'une des faces, correspond une piste de polarité opposée sur la face opposée. Cette disposition permet d'assurer une connexion correcte des pistes d'alimentation avant la connexion des pistes de transmission de données quelle que soit la position du connecteur au moment de l'embrochage. Les diverses positions possibles sont illustrées sur les figures 7 à 9. Il est clair que la disposition des pistes selon la figure 4 assure une connexion correcte aussi bien lorsque le connecteur fait un certain angle avec le plan de la carte - figures 7 et 8 -, que lorsque la face avant du connecteur fait un angle avec le rebord de la carte -figure 9. Dans la position représentée sur la figure 8 et en trait plein sur la figure 7 le contact est assuré par les pistes d'alimentation + et - de la face supérieure de la carte tandis que dans la position représentée en trait pointillé sur la figure 7, ce contact est assuré par les pistes d'alimentation + et - de la face inférieure de la carte. De même, dans la position représentée en trait plein sur la figure 9, les pistes d'alimentation + et - disposées d'un même côté des pistes de transmission de données, sur les faces opposées de la carte, assurent le contact, les deux autres pistes d'alimentation, disposées de l'autre côté des pistes de transmission de données assurant le contact dans la position représentée en trait pointillé sur la figure 9. Un retournement du connecteur, c'est à dire un embrochage de manière à ce que les contacts normalement associés à la face supérieure soient en contact avec la face inférieure de la carte, assure également une connexion correcte des pistes d'alimentation. Bien entendu, dans ce dernier cas les pistes de transmission de données ne sont pas connectées correctement, mais la connexion correcte des pistes d'alimentation évite une détérioration de la mémoire et il suffit alors de retourner le connecteur pour obtenir un fonctionnement correct.

Sur la figure 5 les pistes sont toutes disposées sur la même face de la carte, deux pistes d'alimentation, adjacentes, de polarités opposées étant disposées de part et d'autre des pistes de transmission de données, les deux pistes les plus extérieures étant de même polarité. On peut vérifier que cette disposition permet une connexion correcte à la fois lorsque le connecteur est dans la position représentée en trait plein sur la figure 7 et lorsqu'il est dans les positions représentées sur la figure 9. Si le connecteur est dans la position représentée en pointillé sur la figure 7 ou s'il est retourné par rapport à sa position normale d'embrochage, il n'y a pas connexion des pistes d'alimentation, mais la sécurité de l'ensemble reste garantie car il n'y a pas non plus connexion des pistes de transmission de données.

La figure 6 illustre un troisième mode de réalisation possible, dérivé de celui représenté sur la figure 5, des pistes d'alimentation étant également formées sur la face inférieure de la carte, de manière symétrique par rapport au plan de la carte. Ceci assure alors une connexion correcte des pistes d'alimentation dans tous les cas.

Dans le mode de réalisation représenté sur les figures c'est la carte-mère qui comporte la plage de connexion. Il est également possible de disposer une telle plage sur la carte-fille, le connecteur étant alors solidaire de la carte-mère.

**Revendications**

1. Ensemble de contrôle technique de bâtiment, comportant une unité centrale (110) destinée à être connectée à une pluralité de capteurs (112) et d'actionneurs (114) pour traiter les données fournies par les capteurs et commander les actionneurs, l'unité centrale comportant un microprocesseur (120), au moins une mémoire vive secourue (124), un clavier (128) et un dispositif d'affichage (126), ensemble caractérisé en ce qu'il comporte une mémoire amovible, du type mémoire morte programmable et effaçable électriquement, contenant les paramètres associés à une pluralité de configurations standards correspondant à une pluralité d'applications standards prédéterminées de l'ensemble, la mémoire amovible étant disposée dans une cartouche embrochable (130) destinée à être connectée temporairement à l'unité centrale pour la programmation initiale de l'ensemble. à sa mise en service. de manière à permettre le transfert de la mémoire amovible à la mémoire vive (124) des paramètres associés à une configuration sélectionnée par le clavier (128).

2. Ensemble selon la revendication 1. caractérisé en ce que les paramètres contenus dans la mémoire vive (124) peuvent être affichés successivement sur le dispositif d'affichage (126), et complétés ou modifiés sous le contrôle du clavier (128).

3. Ensemble selon la revendication 2. caractérisé en ce que la mémoire amovible comporte des emplacements de mémoire vides, et certains paramètres introduits dans la mémoire vive étant complétés ou modifiés par l'intermédiaire du clavier, l'ensemble des paramètres est transférable. sous le contrôle du clavier, de la mémoire vive à des emplacements de mémoire vides présélectionnés de la mémoire amovible de manière à constituer une copie de sauvegarde de la configuration modifiée.

4. Ensemble selon l'une quelconque des revendications 1 à 3, caractérisé en ce que la cartouche amovible (130) est susceptible de coopérer successivement avec les unités centrales de plusieurs ensembles de contrôle.

5. Ensemble selon l'une quelconque des revendications 1 à 4, caractérisé en ce que l'unité centrale (110) comporte une première carte de circuit imprimé (10) portant au moins le microprocesseur (120) de l'unité centrale, la cartouche embrochable (130, 14) comportant une seconde carte de circuit imprimé. l'une des deux cartes comportant une plage de connexion (12) de pistes d'alimentation (18) et de pistes de transmission de données (20) sur laquelle est destiné à venir s'embrocher un connecteur (16), solidaire de l'autre carte et connecté électriquement à des pistes d'alimentation et de données de ladite autre carte, les extrémités des pistes d'alimentation (18) de ladite plage de connexion (12) étant décalées par rapport aux extrémités des pistes de transmission de données (20) de ladite plage, de manière à venir en contact avec le connecteur (16) avant ces dernières lors de l'embrochage du connecteur, les pistes d'alimentation étant, dans la plage de connexion, disposées de part et d'autre des pistes de transmission de données.

6. Ensemble selon la revendication 5. caractérisée en ce que le bord de ladite carte est échancré dans la partie de la plage de connexion correspondant aux pistes de transmission de données.

7. Ensemble selon l'une des revendications 5 et 6, caractérisée en ce que la plage de connexion comporte, sur une face de la carte, de part et d'autre des pistes de transmission de données. deux pistes d'alimentation adjacentes de polarités opppposées, les pistes extérieures étant de même polarité.

8. Ensemble selon la revendication 7. caractérisée en ce que ladite carte comporte un circuit imprimé double face, des pistes d'alimentation étant disposées sur les deux faces opposées de la carte de manière symétrique par rapport au plan de la carte.

9. Ensemble selon l'une des revendications 5 et 6, caractérisée en ce que ladite carte comporte un circuit imprimé double face, la plage de connexion comportant sur une première face une piste d'alimentation d'une polarité à une première extrémité et une piste d'alimentation de polarité opposée à l'autre extrémité, et inversement sur la face opposée.

FIG. 1

Fig. 2

Fig. 3

Fig. 4

Fig. 5

Fig. 6

Fig.7

Fig.8

Fig.9

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| Y | FR-A-2356985 (FUJITSU FANUC Ltd) <br> * le document en entier * <br> --- | 1-4 | G05B19/12 <br> H05K1/11 |
| Y | EP-A-102079 (ROTING-WERKE RIEPE KG) <br> * page 7, lignes 1 - 30; revendications 1, 2, 7, 8; figures 1-3 * | 1, 2 | |
| A | --- | 3, 4 | |
| Y | FR-A-2291547 (REGIE NATIONALE DES USINES RENAULT) <br> * le document en entier * | 3, 4 | |
| A | --- | 1, 2 | |
| X | GB-A-1481700 (QUANTEL LTD) <br> * page 1, lignes 13 - 78 * <br> * page 2, lignes 19 - 109; figures 1-4 * | 5-6 | |
| A | --- | 8 | |
| A | EP-A-184657 (FLEXIBLE COMPUTER CORP.) <br> * page 8, alinéa 3 * <br> * page 28, paragraphe: "Physical Arrangements"* <br> * pages 80-81; figue 84 * <br> --- | 5 | |
| A | IBM TECHNICAL DISCLOSURE BULLETIN. <br> vol. 21, no. 4, septembre 1978, NEW YORK US <br> page 1407 ARVANITAKIS N.C. et al.: <br> "Symmetrical Design for Polarized Capacitor" <br> * page 1407 * <br> ------ | 9 | |

**DOMAINES TECHNIQUES RECHERCHES (Int. Cl.5 )**

G05B
H05K
G06F
H01G

Le présent rapport a été établi pour toutes les revendications

| Lieu de la recherche | Date d'achèvement de la recherche | Examinateur |
|---|---|---|
| LA HAYE | 08 FEVRIER 1990 | HAUSER L.E.R. |